# EUROPEAN PATENT APPLICATION

(11) **EP 4 564 403 A1**
(43) Date of publication of application: **04.06.2025**
(21) Application number: 23846541.3
(22) Date of filing: 26.07.2023
(51) Int. Cl.: H01L 21/306, H01L 21/304

(54) **SEMICONDUCTOR SUBSTRATE CLEANING COMPOSITION, AND METHOD FOR PRODUCING SEMICONDUCTOR SUBSTRATE USING SAME**

(30) Priority: 28.07.2022 JP 2022120552
(71) Applicant: MITSUBISHI GAS CHEMICAL COMPANY, INC., Chiyoda-ku Tokyo 100-8324 (JP)
(72) Inventor: OIE, Toshiyuki, Taichung City, 435059 (TW)
(74) Representative: Müller-Boré & Partner Patentanwälte PartG mbB
(86) International application number: PCT/JP2023/027299
(87) International publication number: WO 2024/024811

(57) **Abstract**

Provided is a semiconductor substrate cleaning composition capable of reducing damage to an oxide film while having a high Ti/W etching selectivity ratio.

Disclosed is a semiconductor substrate cleaning composition including: (A) an oxidizing agent; and (B) a metal-tungsten corrosion inhibitor, wherein the semiconductor substrate cleaning composition does not include (C) a fluorine compound or further contains the fluorine compound in an amount of less than 0.005% by mass with respect to a total mass of the semiconductor substrate cleaning composition, and the semiconductor substrate cleaning composition has a pH of 7 or less.

## Description

### Technical Field

The present invention relates to a semiconductor substrate cleaning composition and a method for producing a semiconductor substrate using the same.

### Background Art

In recent years, miniaturization and high functionality of an electronic device have been promoted, and further miniaturization, high functionality, and the like of a semiconductor substrate constituting the electronic device are required.

Metallic tungsten is suitably used for a semiconductor substrate that can be downsized and highly functionalized. Metal tungsten can be formed into a film by chemical vapor deposition (CVD), and has characteristics that electromigration hardly occurs, electrical resistance is low, and heat resistance is high. Metal tungsten is used for a gate electrode and the like in a semiconductor substrate.

Titanium and/or a titanium alloy are suitably used for a semiconductor substrate using metal tungsten and a method for producing the same. For example, a titanium-containing film containing titanium and/or a titanium alloy can be a constituent element of a semiconductor substrate as a barrier metal film. The titanium-containing film can prevent diffusion of metal tungsten as a barrier metal film.

In addition, the titanium-containing film containing titanium and/or a titanium alloy can be used as a metal hard mask for pattern formation or the like in a manufacturing process of the semiconductor substrate. By using the titanium-containing film as a metal hard mask, pattern formation can be suitably performed.

A part or all of the titanium-containing film containing titanium and/or a titanium alloy used in a semiconductor substrate containing metal tungsten and a method for manufacturing the same is etched in order to obtain a desired configuration of the semiconductor substrate or to perform a set manufacturing process. In such etching of the titanium-containing film, metal tungsten is required not to be damaged, and therefore etching selectivity ratio (Ti/W etching selectivity ratio) of a titanium-titanium alloy is required to be high.

As a method for etching a titanium-titanium alloy with a high Ti/W etching selectivity ratio, for example, Patent Literature 1 describes an invention related to an etching method for selectively etching titanium nitride or titanium by dry etching. More specifically, the invention according to Patent Literature 1 is an etching method including: preparing a substrate on which titanium nitride or titanium and another substance (metal film such as tungsten) are present; supplying a hydrogen-containing gas to the substrate; and supplying a chlorine trifluoride gas to the substrate to selectively etch the titanium nitride or the titanium.

Patent Literature 1 describes that titanium nitride or titanium is selectively etched by supplying a hydrogen-containing gas to embrittle titanium nitride or the like in advance and then supplying a chlorine trifluoride gas, whereby a selection ratio of titanium nitride or titanium to another film (metal film such as tungsten) becomes 5 or more.

### Citation List

### Patent Literature

Patent Literature 1: JP 2022-066687 A

### Summary of Invention

### Technical Problem

According to the method by dry etching described in Patent Literature 1, a titanium-titanium alloy can be etched with a high Ti/W etching selectivity ratio. However, in dry etching, an interlayer insulating film constituting a semiconductor substrate, specifically, an oxide film containing an oxide having a relative dielectric constant of 60 or less may be damaged, and a semiconductor substrate having desired performance may not be obtained.

Therefore, the present invention provides a semiconductor substrate cleaning composition capable of reducing damage to an oxide film while having a high Ti/W etching selectivity ratio.

### Solution to Problem

The present invention provides, for example, the following etching compositions.

[1] A semiconductor substrate cleaning composition including:
   (A) an oxidizing agent; and
   (B) a metal-tungsten corrosion inhibitor, wherein

   the semiconductor substrate cleaning composition does not include (C) a fluorine compound or further includes the fluorine compound in an amount of less than 0.005% by mass with respect to a total mass of the semiconductor substrate cleaning composition, and
   the semiconductor substrate cleaning composition has a pH of 7 or less.
[2] The semiconductor substrate cleaning composition according to [1], wherein the semiconductor substrate cleaning composition does not include the (C) fluorine compound.
[3] The semiconductor substrate cleaning composition according to [1] or [2], wherein the pH is 0.5 to 3.
[4] The semiconductor substrate cleaning composition according to any one of [1] to [3], wherein the (A) oxidizing agent includes at least one selected from a group consisting of a peracid, a halogen oxoacid, and a salt thereof.
[5] The semiconductor substrate cleaning composition according to any one of [1] to [4], wherein the (B) metal-tungsten corrosion inhibitor includes at least one selected from a group consisting of an ammonium salt represented by a formula (1) and a heteroaryl salt having a substituted or unsubstituted alkyl group having 10 to 30 carbon atoms, 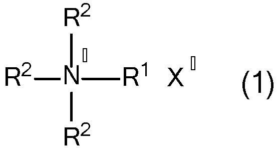 (in the formula (1),
   R¹ is the substituted or unsubstituted alkyl group having 10 to 30 carbon atoms, a substituted or unsubstituted alkyl (poly) heteroalkylene group having 10 to 30 carbon atoms, or a substituted or unsubstituted aryl (poly) heteroalkylene group having 10 to 30 carbon atoms,
   R² is each independently the substituted or unsubstituted alkyl group having 1 to 30 carbon atoms, or a substituted or unsubstituted aryl group having 6 to 30 carbon atoms, and
   X⁻ is a halide ion, a hydroxide ion, an organic sulfonate ion, a tetrafluoroborate anion, or a hexafluorophosphate anion).
[6] The semiconductor substrate cleaning composition according to [5], wherein the R¹ is the substituted or unsubstituted aryl (poly) heteroalkylene group having 10 to 30 carbon atoms, and at least one of the R²s is the substituted or unsubstituted aryl group having 6 to 30 carbon atoms.
[7] A method for producing a semiconductor substrate, the method including a step of causing the semiconductor substrate including a titanium-containing film containing at least one of titanium and a titanium alloy, a metal tungsten film, and an oxide film containing an oxide having a relative dielectric constant of 60 or less to contact the semiconductor substrate cleaning composition according to any one of [1] to [6] so as to remove at least a part of the titanium-containing film.

### Advantageous Effects of Invention

According to the present invention, there is provided a semiconductor substrate cleaning composition capable of reducing damage to an oxide film while having a high Ti/W etching selectivity ratio.

### Brief Description of Drawings

Fig. 1 is a schematic diagram related to an example of an etching step of a semiconductor substrate when a titanium-containing film is used as a barrier metal film.
Fig. 2 is a schematic diagram related to the example of the etching step of the semiconductor substrate when the titanium-containing film is used as the barrier metal film.
Fig. 3 is a schematic diagram related to an example of an etching step of a semiconductor substrate when a titanium-containing film is used as a metal hard mask.

### Description of Embodiments

Hereinafter, embodiments for carrying out the present invention will be described in detail.

### <Semiconductor Substrate Cleaning Composition>

The semiconductor substrate cleaning composition according to the present invention contains (A) an oxidizing agent and (B) a metal-tungsten corrosion inhibitor. At this time, the semiconductor substrate cleaning composition does not contain (C) a fluorine compound, or further contains a fluorine compound in an amount of less than 0.005% by mass with respect to the total mass of the semiconductor substrate cleaning composition. The pH of the semiconductor substrate cleaning composition is 7 or less.

By using the semiconductor substrate cleaning composition, it is possible to provide a semiconductor substrate cleaning composition capable of reducing damage to an oxide film while having a high Ti/W etching selectivity ratio. Hereinafter, the present invention will be described with reference to the drawings. Note that the drawings may be exaggerated for the sake of explanation and may be different from actual dimensions.

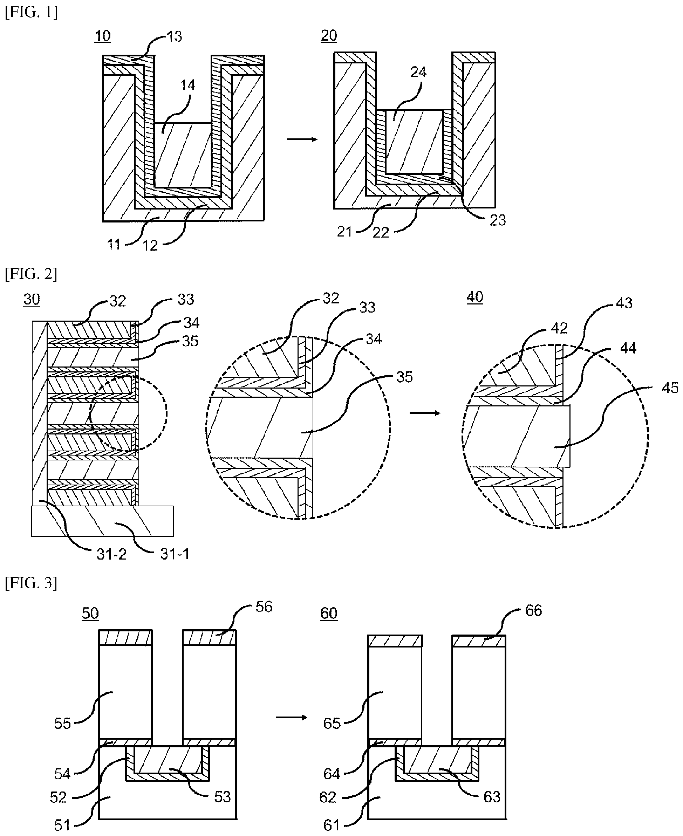

Fig. 1 is a schematic diagram related to an example of an etching step of a semiconductor substrate when a titanium-containing film is used as a barrier metal film. A semiconductor substrate (before etching) 10 includes a silicon substrate 11 having a recessed portion formed therein, an insulating film 12 made of silicon dioxide, a barrier metal film (before etching) 13 made of titanium nitride, and a metal tungsten film 14. Such a semiconductor substrate (before etching) 10 can be manufactured by sequentially forming an insulating film made of silicon dioxide, a barrier metal film made of titanium nitride, and a metal tungsten film on a silicon substrate having a recessed portion formed therein, and etching the metal tungsten film.

A semiconductor substrate (after etching) 20 can be obtained by applying the semiconductor substrate cleaning composition according to the present invention to the semiconductor substrate (before etching) 10. Specifically, when the semiconductor substrate cleaning composition according to the present invention is applied to the semiconductor substrate (before etching) 10, the barrier metal film (before etching) 13 made of titanium nitride is selectively etched to become a barrier metal film (after etching) 23 made of titanium nitride. Here, since the semiconductor substrate cleaning composition according to the present invention has a high Ti/W etching selectivity ratio, the metal tungsten film 14 before etching is not etched (corroded) or hardly etched (corroded), and becomes a metal tungsten film 24. In addition, when the etching progresses, the insulating film 12 made of silicon dioxide is exposed, and a chance of contacting the semiconductor substrate cleaning composition according to the present invention increases, thereby entering a situation in which damage due to etching or the like is likely to occur. However, since the semiconductor substrate cleaning composition according to the present invention hardly etches an oxide film, the insulating film 12 is hardly damaged in the etching process and becomes an insulating film 22. As a result, the semiconductor substrate 20 having desired performance can be obtained.

Further, Fig. 2 is a schematic diagram related to the example of the etching step of the semiconductor substrate when the titanium-containing film is used as the barrier metal film. A semiconductor substrate (before etching) 30 includes a silicon substrate 31-1 and polysilicon 31-2, an insulating film 32 made of silicon dioxide, a high dielectric constant insulating film (High-k film) 33 made of aluminum oxide, a barrier metal film (before etching) 34 made of titanium nitride, and a metal tungsten film 35. Such a semiconductor substrate (before etching) 30 can be manufactured by sequentially forming a high dielectric constant insulating film (High-k film) made of aluminum oxide, a barrier metal film made of titanium nitride, and a metal tungsten film on an insulating film made of silicon dioxide disposed at regular intervals on a silicon substrate and polysilicon, and etching only the metal tungsten film.

By applying the semiconductor substrate cleaning composition according to the present invention to the semiconductor substrate (before etching) 30, a semiconductor substrate (after etching) 40 can be obtained (Fig. 2 illustrates only an enlarged view of the semiconductor substrate (after etching) 40). Specifically, when the semiconductor substrate cleaning composition according to the present invention is applied to the semiconductor substrate (before etching) 30, the barrier metal film (before etching) 34 made of titanium nitride is partially selectively etched to become a barrier metal film (after etching) 44 made of titanium nitride. Here, since the semiconductor substrate cleaning composition according to the present invention has a high Ti/W etching selectivity ratio, the metal tungsten film 35 before etching is not etched (corroded) or hardly etched (corroded), and becomes a metal tungsten film 45. In addition, since the semiconductor substrate cleaning composition according to the present invention hardly etches the oxide film, the high dielectric constant insulating film (High-k film) 33 made of aluminum oxide is hardly damaged in the etching process, and becomes a high dielectric constant insulating film (High-k film) 43 made of aluminum oxide. That is, in the manufacturing process of the semiconductor substrate (after etching) 40, the metal tungsten film 45 is not etched (corroded), and the high dielectric constant insulating film (High-k film) 43 made of aluminum oxide is hardly damaged, so that the obtained semiconductor substrate 40 can have desired performance.

Further, Fig. 3 is a schematic diagram related to an example of an etching step of a semiconductor substrate when a titanium-containing film is used as a metal hard mask. A semiconductor substrate (before etching) 50 includes a silicon substrate 51 having a recessed portion formed therein, a barrier metal film 52 and a metal tungsten film 53 made of titanium nitride embedded in the recessed portion, a cap film 54, a low dielectric constant insulating film (low-k film) 55, and a metal hard mask (before etching) 56 made of titanium nitride. Such a semiconductor substrate (before etching) 50 can be manufactured by a damascene process, a dual damascene process, or the like. For example, a hard mask is stacked on a silicon substrate, a pattern is formed on the hard mask, and then a silicon substrate is etched using the hard mask as a mask to form a recessed portion in the silicon substrate. After removal of the hard mask, a barrier metal film and a metal tungsten film are sequentially formed in the recessed portion, and then planarized by chemical mechanical polishing (CMP). Next, a cap film and a low dielectric constant insulating film (low-k film) are sequentially formed on the silicon substrate in which the barrier metal film and the metal tungsten film are embedded in the recessed portion. Subsequently, a metal hard mask made of titanium nitride is stacked on the low dielectric constant insulating film (low-k film), a pattern is formed on the metal hard mask, and then the low dielectric constant insulating film (low-k film) is etched to form a via hole, thereby making it possible to manufacture the semiconductor substrate (before etching) 50.

A semiconductor substrate (after etching) 60 can be obtained by applying the semiconductor substrate cleaning composition according to the present invention to the semiconductor substrate (before etching) 50. Specifically, when the semiconductor substrate cleaning composition according to the present invention is applied to the semiconductor substrate (before etching) 50, the metal hard mask (before etching) 56 made of titanium nitride is selectively partially etched, thereby obtaining a metal hard mask (after etching) 66 made of titanium nitride and formed to have a cleaned surface thereof. Here, since the semiconductor substrate cleaning composition according to the present invention has a high Ti/W etching selectivity ratio, the metal tungsten film 53 before etching is not etched (corroded) or hardly etched (corroded), and becomes a metal tungsten film 63. In addition, since the semiconductor substrate cleaning composition according to the present invention hardly etches the oxide film, the low dielectric constant insulating film (low-k film) 55 is hardly damaged in the etching process, and becomes the low dielectric constant insulating film (low-k film) 65. That is, in the manufacturing process of the semiconductor substrate (after etching) 60, the metal tungsten film 63 is not etched (corroded), and the low dielectric constant insulating film (low-k film) 65 is hardly damaged, thereby making it possible to obtain the semiconductor substrate 60 having desired performance.

In the present specification, the "titanium alloy" means one having a metallic property in which one or more kinds of metal elements other than titanium or non-metal elements are added to titanium. At this time, the content of the titanium element in the titanium alloy is 20 atomic weight% or more, preferably 30 atomic weight% or more, more preferably 35 atomic weight% or more, and still more preferably 40 to 99.9 atomic weight% with respect to the total atomic weight of the titanium alloy. Examples of elements other than titanium that can be contained in the titanium alloy include aluminum, oxygen, nitrogen, carbon, molybdenum, vanadium, niobium, iron, chromium, nickel, tin, hafnium, zirconium, palladium, ruthenium, and platinum. These elements other than titanium may be contained alone in the titanium alloy, or two or more kinds of the elements may be contained therein.

Hereinafter, the semiconductor substrate cleaning composition according to the present invention will be described in detail.

### [(A) Oxidizing Agent]

(A) An oxidizing agent has a function of changing the number of oxides of titanium and titanium in the titanium alloy to tetravalent.

The (A) oxidizing agent is not particularly limited, and examples thereof include peracid, halogen oxoacid, and salt thereof.

Examples of the peracid include hydrogen peroxide, persulfuric acid, percarbonic acid, perphosphoric acid, peracetic acid, perbenzoic acid, and meta-chloroperbenzoic acid.

Examples of the halogen oxoacid include oxoacids of chlorine such as hypochlorous acid, chlorous acid, chloric acid, and perchloric acid; oxoacids of bromine such as hypobromous acid, bromous acid, bromic acid, and perbromic acid; and oxoacids of iodine such as hypoiodous acid, iodous acid, iodic acid, and periodic acid.

Examples of the salt include alkali metal salts such as a lithium salt, a sodium salt, a potassium salt, a rubidium salt, and a cesium salt of the peracid or the halogen oxyacid; an alkaline earth metal salts such as a beryllium salt, a magnesium salt, a calcium salt, a strontium salt, and a barium salt of the peracid or the halogen oxyacid; metal salts such as an aluminum salt, a copper salt, a zinc salt, and a silver salt of the peracid or the halogen oxyacid; and an ammonium salt of the peracid or the halogen oxyacid.

The (A) oxidizing agent described above is preferably hydrogen peroxide or an oxoacid of iodine, more preferably hydrogen peroxide, iodic acid, or periodic acid, still more preferably iodic acid or periodic acid, and from the viewpoint of further increasing the Ti/W etching selectivity ratio, iodic acid is particularly preferable.

The (A) oxidizing agent described above may be used alone, or two or more kinds thereof may be used in combination. That is, in one embodiment, the (A) oxidizing agent preferably contains at least one selected from the group consisting of a periodic acid, a halogen oxoacid, and salts thereof, more preferably contains at least one selected from the group consisting of hydrogen peroxide and an oxoacid of iodine, still more preferably contains at least one selected from the group consisting of hydrogen peroxide, iodic acid, and periodic acid, particularly preferably contains at least one selected from the group consisting of iodic acid and periodic acid, and most preferably contains iodic acid.

An addition rate of the (A) oxidizing agent is preferably 0.0001 to 20% by mass, more preferably 0.001 to 15% by mass with respect to the total mass of the semiconductor substrate cleaning composition, and from the viewpoint of increasing the etching rate of titanium and the titanium alloy, the addition rate is still more preferably 0.01 to 15% by mass, still further more preferably 0.3 to 12.5% by mass, particularly preferably 0.3 to 5% by mass, and most preferably 0.5 to 3 by mass.

### [(B) Metal-tungsten Corrosion Inhibitor]

(B) A metal-tungsten corrosion inhibitor is adsorbed to metal tungsten to form a protective film, and has a function of preventing or suppressing etching by the semiconductor substrate cleaning composition.

The (B) metal-tungsten corrosion inhibitor is not particularly limited, but includes at least one selected from the group consisting of an ammonium salt represented by the following formula (1) and a heteroaryl salt having a substituted or unsubstituted alkyl group having 10 to 30 carbon atoms.

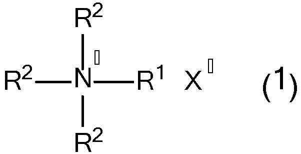

In the above formula (1), R¹ is a substituted or unsubstituted alkyl group having 10 to 30 carbon atoms, a substituted or unsubstituted alkyl (poly) heteroalkylene group having 10 to 30 carbon atoms, or a substituted or unsubstituted aryl (poly) heteroalkylene group having 10 to 30 carbon atoms.

The alkyl group having 10 to 30 carbon atoms is not particularly limited, and examples thereof include a decyl group, a dodecyl group, a tetradecyl group, a pentadecyl group, a hexadecyl group, a heptadecyl group, an octadecyl group, a nonadecyl group, an icosyl group, a docosyl group, a tetracosyl group, a hexacosyl group, an octacosyl group, and a triacontyl group.

A substituent in a case where the substituted or unsubstituted alkyl group having 10 to 30 carbon atoms has a substituent (substituted alkyl group having 10 to 30 carbon atoms) is not particularly limited, and examples thereof include a halogen atom such as a fluorine atom, a chlorine atom, a bromine atom, or an iodine atom; an aryl group having 6 to 20 carbon atoms, such as a phenyl group or a naphthyl group; an alkoxy group having 1 to 6 carbon atoms, such as a methoxy group, an ethoxy group, or a propyloxy group; a hydroxy group; a cyano group; and a nitro group. Note that the number of substituents may be one or two or more. In addition, the substituted alkyl group having 10 to 30 carbon atoms means that the total number of carbon atoms of the substituent and the alkyl group is 10 to 30. That is, in the case of the substituted alkyl group having 10 to 30 carbon atoms, the number of carbon atoms of the alkyl group can be 10 or less (for example, an alkyl group having 8 to 13 carbon atoms, such as an octyl group, a decyl group, or a dodecyl group) according to the number of carbon atoms of the substituent.

The alkyl (poly) heteroalkylene group having 10 to 30 carbon atoms is represented by -(CₙH₂ₙ-Z-)ₘ-R³. In this case, n is each independently 1 to 5, preferably 1 to 3, and more preferably 1 and 2. m is 1 to 5 and is preferably 1 and 2. Z is each independently an oxygen atom (O), a sulfur atom (S), or a phosphorus atom (P), and is preferably an oxygen atom (O). R³ is an alkyl group having 1 to 30 carbon atoms, and examples thereof include a methyl group, an ethyl group, a propyl group, an isopropyl group, a butyl group, a pentyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group, and an icosyl group.

A substituent in a case where the substituted or unsubstituted alkyl (poly) heteroalkylene group having 10 to 30 carbon atoms has a substituent (substituted alkyl (poly) heteroalkylene group having 10 to 30 carbon atoms) is not particularly limited, and examples thereof include a halogen atom such as a fluorine atom, a chlorine atom, a bromine atom, or an iodine atom; an aryl group having 6 to 20 carbon atoms, such as a phenyl group or a naphthyl group; an alkoxy group having 1 to 6 carbon atoms, such as a methoxy group, an ethoxy group, or a propyloxy group; a hydroxy group; a cyano group; and a nitro group. Note that the substituent is usually substituted with a hydrogen atom of R³. Further, the number of substituents may be one or may be two or more. Further, the substituted alkyl (poly) heteroalkylene group having 10 to 30 carbon atoms means that the total number of carbon atoms of the substituent and the alkyl (poly) heteroalkylene group is 10 to 30. That is, in the case of the substituted alkyl (poly) heteroalkylene group having 10 to 30 carbon atoms, the number of carbon atoms of the alkyl (poly) heteroalkylene group can be 10 or less (for example, an alkyl group having 8 to 13 carbon atoms, such as an octyl group, a decyl group, or a dodecyl group) according to the number of carbon atoms of the substituent.

The aryl (poly) heteroalkylene group having 10 to 30 carbon atoms is represented by -(CₙH₂ₙ-Z-)ₘ-Ar. In this case, n is each independently 1 to 5, preferably 1 to 3, and more preferably 1 and 2. m is 1 to 5 and is preferably 1 and 2. Z is each independently an oxygen atom (O), a sulfur atom (S), or a phosphorus atom (P), and is preferably an oxygen atom (O). Ar is an aryl group having 6 to 18 carbon atoms, and examples thereof include a phenyl group, a naphthyl group, and an anthracenyl group.

A substituent in a case where the substituted or unsubstituted aryl (poly) heteroalkylene group having 10 to 30 carbon atoms has a substituent (substituted aryl (poly) heteroalkylene group having 10 to 30 carbon atoms) is not particularly limited, and examples thereof include a halogen atom such as a fluorine atom, a chlorine atom, a bromine atom, or an iodine atom; an alkyl group having 1 to 10 carbon atoms, such as a methyl group, an ethyl group, a propyl group, an isopropyl group, a butyl group, a 1,1-dimethylbutyl group, a 2,2-dimethylbutyl group, and a 1,1,3,3-tetramethylbutyl group; an alkoxy group having 1 to 6 carbon atoms, such as a methoxy group, an ethoxy group, or a propyloxy group; a hydroxy group; a cyano group; a nitro group. Note that the substituent is usually substituted with a hydrogen atom of Ar. Further, the number of substituents may be one or may be two or more. Further, the substituted aryl (poly) heteroalkylene group having 10 to 30 carbon atoms means that the total number of carbon atoms of the substituent and the carbon atoms of the aryl (poly) heteroalkylene group is 10 to 30. That is, in the case of the substituted aryl (poly) heteroalkylene group having 10 to 30 carbon atoms, the number of carbon atoms of the aryl (poly) heteroalkylene group can be 10 or less (for example, an alkyl group having 8 to 13 carbon atoms, such as an octyl group, a decyl group, or a dodecyl group) according to the number of carbon atoms of the substituent.

In one embodiment, R¹ is preferably a substituted or unsubstituted alkyl (poly) heteroalkylene group having 10 to 30 carbon atoms or a substituted or unsubstituted aryl (poly) heteroalkylene group having 10 to 30 carbon atoms, more preferably a substituted or unsubstituted aryl (poly) heteroalkylene group having 10 to 20 carbon atoms, still more preferably a substituted or unsubstituted aryl (poly) heteroalkylene group having 16 to 20 carbon atoms, particularly preferably a substituted or unsubstituted aryl (poly) heteroalkylene group having 18 to 20 carbon atoms, and most preferably a p-(1,1,3,3-tetramethylbutyl)phenyldi(oxyethylene)(p-CH₃C(CH₃)₂CH₂C(CH₃)₂-Ph-(O-C₂H₄)₂-) group.

In another embodiment, R¹ is preferably a substituted or unsubstituted alkyl group having 10 to 25 carbon atoms and a substituted or unsubstituted aryl (poly) heteroalkylene group having 10 to 25 carbon atoms, more preferably a substituted or unsubstituted alkyl group having 12 to 20 carbon atoms and a substituted or unsubstituted aryl (poly) heteroalkylene group having 12 to 20 carbon atoms, still more preferably a dodecyl group, a tetradecyl group, a hexadecyl group, an octadecyl group, and a p-(1,1,3,3-tetramethylbutyl)phenyldi(oxyethylene)(p-CH₃C (CH₃)₂CH₂C(CH₃)₂-Ph-(O-C₂H₄)₂-) group, particularly preferably a hexadecyl group, an octadecyl group, and a p-(1,1,3,3-tetramethylbutyl)phenyldi(oxyethylene)(p-CH₃C(CH₃)₂CH₂C(CH₃)₂-Ph-(O-C₂H₄)₂-) group, and most preferably a p-(1,1,3,3-tetramethylbutyl)phenyldi(oxyethylene)(p-CH₃C(CH₃)₂CH₂C(CH₃)₂-Ph-(O-C₂H₄)₂-) group.

R² is each independently a substituted or unsubstituted alkyl group having 1 to 30 carbon atoms, or a substituted or unsubstituted aryl group having 6 to 30 carbon atoms.

The alkyl group having 1 to 30 carbon atoms is not particularly limited, and examples thereof include a methyl group, an ethyl group, a propyl group, an isopropyl group, a butyl group, an isobutyl group, a sec-butyl group, a tert-butyl group, a pentyl group, a hexyl group, a heptyl group, an octyl group, a nonyl group, a decyl group, a dodecyl group, a tetradecyl group, a hexadecyl group, an octadecyl group, a nonadecyl group, and an icosyl group.

Examples of a substituent in a case where the substituted or unsubstituted alkyl group having 1 to 30 carbon atoms has a substituent (substituted alkyl group having 1 to 30 carbon atoms) include a halogen atom such as a fluorine atom, a chlorine atom, a bromine atom, or an iodine atom; an aryl group having 6 to 20 carbon atoms, such as a phenyl group or a naphthyl group; an alkoxy group having 1 to 6 carbon atoms, such as a methoxy group, an ethoxy group, or a propyloxy group; a hydroxy group; a cyano group; and a nitro group. Note that the number of substituents may be one or two or more. In addition, the substituted alkyl group having 1 to 30 carbon atoms means that the total number of carbon atoms of the substituent and the alkyl group is 1 to 30.

The aryl group having 6 to 30 carbon atoms is not particularly limited, and examples thereof include a phenyl group, a naphthyl group, and a biphenyl group.

Examples of a substituent in a case where the substituted or unsubstituted aryl group having 6 to 30 carbon atoms has a substituent (substituted aryl group having 6 to 30 carbon atoms) include a halogen atom such as a fluorine atom, a chlorine atom, a bromine atom, or an iodine atom; an alkyl group having 1 to 10 carbon atoms, such as a methyl group, an ethyl group, a propyl group, or an isopropyl group; an alkoxy group having 1 to 6 carbon atoms, such as a methoxy group, an ethoxy group, or a propyloxy group; a hydroxy group; a cyano group; and a nitro group. Note that the number of substituents may be one or two or more. In addition, the substituted aryl group having 6 to 30 carbon atoms means that the total number of carbon atoms of the substituent and the aryl group is 6 to 30.

Among them, R² is preferably a substituted or unsubstituted alkyl group having 1 to 30 carbon atoms, more preferably a methyl group, an ethyl group, a propyl group, an isopropyl group, a hexyl group, an octyl group, a decyl group, a dodecyl group, a tetradecyl group, a hexadecyl group, an octadecyl group, a benzyl group, a hydroxymethyl group, or a 2-hydroxyethyl group, still more preferably a methyl group, an ethyl group, a benzyl group, or a 2-hydroxyethyl group, particularly preferably a methyl group or a benzyl group, and most preferably a methyl group. In another embodiment, R² is preferably an alkyl group having 1 to 10 carbon atoms substituted with an aryl group having 6 to 20 carbon atoms, more preferably an alkyl group having 1 to 5 carbon atoms substituted with a phenyl group, still more preferably a benzyl group or a phenylethyl group, and particularly preferably a benzyl group.

X represents a halide ion (fluoride ion, chloride ion, bromide ion, iodide ion, and the like), a hydroxide ion, an organic sulfonate ion (methanesulfonate ion, p-toluenesulfonate ion, and the like), a tetrafluoroborate anion, or a hexafluorophosphate anion. Among them, X is preferably a halide ion, and more preferably a chloride ion or a bromide ion.

Specific examples of an ammonium salt represented by the formula (1) in which R¹ is a substituted or unsubstituted alkyl group having 10 to 30 carbon atoms include ammonium salts having a decyl group, such as decyltrimethylammonium bromide and benzyldimethyldecylammonium chloride; ammonium salts having a dodecyl group, such as dodecyltrimethylammonium bromide and benzyldimethyldodecylammonium chloride; ammonium salts having a tetradecyl group, such as tetradecyltrimethylammonium bromide and benzyldimethyltetradecylammonium chloride; ammonium salts having a hexadecyl group, such as hexadecyltrimethylammonium chloride, hexadecyltrimethylammonium bromide, hexadecyltrimethylammonium p-toluenesulfonate, hexadecyltrimethylammonium hydroxide, ethylhexadecyldimethylammonium chloride, ethylhexadecyldimethylammonium bromide, and benzyldimethylhexadecylammonium chloride; and ammonium salts having an octadecyl group, such as trimethyloctadecylammonium chloride, trimethyloctadecylammonium bromide, dimethyldioctadecylammonium chloride, dimethyldioctadecylammonium bromide, and benzyldimethyloctadecylammonium chloride.

Specific examples of an ammonium salt represented by the formula (1) in which R¹ is a substituted or unsubstituted alkyl (poly) heteroalkylene group having 10 to 30 carbon atoms include trimethylpropyldi(oxyethylene)ammonium chloride and trimethylpropyloxyethylenethioethyleneammonium chloride.

Specific examples of an ammonium salt represented by the formula (1) in which R¹ is a substituted or unsubstituted aryl (poly) heteroalkylene group having 10 to 30 carbon atoms include benzyldimethyl-2-{2-[4-(1,1,3,3-tetramethylbutyl)phenoxy]ethoxy}ethylammonium chloride(benzetonium chloride) and benzyldimethylphenyldi(oxyethylene)ammonium chloride.

In one embodiment, in the ammonium salt represented by the formula (1), it is preferable that R¹ is a substituted or unsubstituted aryl (poly) heteroalkylene group having 10 to 30 carbon atoms, and at least one of R²s is a substituted or unsubstituted aryl group having 6 to 30 carbon atoms, it is more preferable that R¹ is a substituted or unsubstituted aryl (poly) heteroalkylene group having 16 to 20 carbon atoms, and at least one of R²s is a substituted or unsubstituted aryl group having 6 to 15 carbon atoms, it is further preferable that R¹ is a substituted or unsubstituted aryl (poly) heteroalkylene group having 18 to 20 carbon atoms, and at least one of R²s is a substituted or unsubstituted aryl group having 6 to 12 carbon atoms, and it is particularly preferable that the ammonium salt is benzyldimethyl-2-{2-[4-(1,1,3,3-tetramethylbutyl)phenoxy]ethoxy}ethylammonium chloride(benzetonium chloride). When R¹ and at least one R² contain the aryl group, the ammonium salt represented by the formula (1) is easily adsorbed by metal tungsten, and the Ti/W etching selectivity ratio can be preferably higher.

The heteroaryl salt having a substituted or unsubstituted alkyl group having 10 to 30 carbon atoms is not particularly limited, and examples thereof include salts of heteroaryl cations formed by bonding at least one of nitrogen atoms of a substituted or unsubstituted nitrogen atom-containing heteroaryl ring to a substituted or unsubstituted alkyl group having 10 to 30 carbon atoms.

The nitrogen atom-containing heteroaryl ring is not particularly limited, and examples thereof include rings such as imidazole, pyrazole, oxazole, isoxazole (isoxazole), thiazole, isothiazole, pyridine, pyrazine, pyridazine, pyrimidine, quinoline, and isoquinoline.

In this case, examples of a substituent in a case where the nitrogen atom-containing heteroaryl ring has a substituent include a halogen atom such as a fluorine atom, a chlorine atom, a bromine atom, or an iodine atom; an alkyl group having 1 to 4 carbon atoms, such as a methyl group, an ethyl group, a propyl group, or an isopropyl group; an aryl group having 6 to 20 carbon atoms, such as a phenyl group or a naphthyl group; an alkoxy group having 1 to 6 carbon atoms, such as a methoxy group, an ethoxy group, or a propyloxy group; a hydroxy group; a cyano group; and a nitro group.

The alkyl group having 10 to 30 carbon atoms is not particularly limited, and examples thereof include a decyl group, a dodecyl group, a tetradecyl group, a pentadecyl group, a hexadecyl group, a heptadecyl group, an octadecyl group, a nonadecyl group, an icosyl group, a docosyl group, a tetracosyl group, a hexacosyl group, an octacosyl group, and a triacontyl group.

Examples of a substituent in a case where the substituted or unsubstituted alkyl group having 10 to 30 carbon atoms has a substituent (substituted alkyl group having 10 to 30 carbon atoms) include a halogen atom such as a fluorine atom, a chlorine atom, a bromine atom, or an iodine atom; an alkyl group having 1 to 4 carbon atoms, such as a methyl group, an ethyl group, a propyl group, or an isopropyl group; an aryl group having 6 to 20 carbon atoms, such as a phenyl group or a naphthyl group; an alkoxy group having 1 to 6 carbon atoms, such as a methoxy group, an ethoxy group, or a propyloxy group; a hydroxy group; a cyano group; and a nitro group. Note that the number of substituents may be one or two or more. In addition, the substituted alkyl group having 10 to 30 carbon atoms means that the total number of carbon atoms of the substituent and the alkyl group is 10 to 30. That is, in the case of the substituted alkyl group having 10 to 30 carbon atoms, the number of carbon atoms of the alkyl group can be 10 or less (for example, an alkyl group having 8 to 13 carbon atoms, such as an octyl group, a decyl group, or a dodecyl group) according to the number of carbon atoms of the substituent.

Among them, the substituted or unsubstituted alkyl group having 10 to 30 carbon atoms is preferably a substituted or unsubstituted alkyl group having 10 to 20 carbon atoms, more preferably an alkyl group having 10 to 20 carbon atoms, still more preferably a dodecyl group, a tetradecyl group, a hexadecyl group, or an octadecyl group, particularly preferably a dodecyl group, a tetradecyl group, or a hexadecyl group from the viewpoint of increasing the Ti/W etching selectivity ratio, and most preferably a dodecyl group or a tetradecyl group.

A counter anion of the heteroaryl cation having a substituted or unsubstituted alkyl group having 10 to 30 carbon atoms is not particularly limited, and examples thereof include a halide ion such as a fluoride ion, a chloride ion, a bromide ion, or an iodide ion; a hydroxide ion; an organic sulfonic acid ion such as a methanesulfonic acid ion or a p-toluenesulfonic acid ion; a tetrafluoroborate anion; and a hexafluorophosphate anion. Among these, the counter anion is preferably a halide ion and is more preferably a chloride ion or a bromide ion.

Specific examples of the heteroaryl salt having a substituted or unsubstituted alkyl group having 10 to 30 carbon atoms include imidazolium salts such as 1-decyl-3 methylimidazolium chloride, 1-decyl-3-methylimidazolium bromide, 1-dodecyl-3-methylimidazolium chloride, 1-dodecyl-3-methylimidazolium bromide, 1-tetradecyl-3-methylimidazolium chloride, 1-tetradecyl-3-methylimidazolium bromide, 1-hexadecyl-3-methylimidazolium chloride, 1-hexadecyl-3-methylimidazolium bromide, 1-octadecyl-3-methylimidazolium chloride, and 1-octadecyl-3-methylimidazolium bromide; oxazolium salts such as 3-decyl oxazolium chloride, 3-dodecyl oxazolium chloride, 3-tetradecyl oxazolium chloride, 3-hexadecyl oxazolium chloride, and 3-octadecyl oxazolium chloride; thiazolium salts such as 3-decylthiazolium chloride, 3-dodecylthiazolium chloride, 3-tetradecylthiazolium chloride, 3-hexadecylthiazolium chloride, and 3-octadecylthiazolium chloride; pyridinium salts such as 1-decylpyridinium chloride, 1-dodecylpyridinium chloride, 1-tetradecylpyridinium chloride, 1-tetradecylpyridinium bromide, 1-hexadecylpyridinium chloride, 1-hexadecylpyridinium bromide, 1-octadecylpyridinium chloride, and 1-octadecylpyridinium bromide; pyrimidinium salts such as 1-decylpyrimidinium chloride, 1-dodecylpyrimidinium chloride, 1-tetradecylpyrimidinium chloride, 1-hexadecylpyrimidinium chloride, and 1-octadecylpyrimidinium chloride; quinolinium salts such as decylquinolinium chloride, dodecylquinolinium chloride, tetradecylquinolinium chloride, hexadecylquinolinium chloride, and octadecylquinolinium chloride; and isoquinolinium salts such as decyl isoquinolinium chloride, dodecyl isoquinolinium chloride, tetradecyl isoquinolinium chloride, hexadecyl isoquinolinium chloride, and octadecyl isoquinolinium chloride. Furthermore, these salts may be used as hydrates.

Among them, from the viewpoint of increasing the Ti/W etching selectivity ratio, the (B) metal-tungsten corrosion inhibitor is preferably an ammonium salt represented by the formula (1) (here, R¹ is a substituted or unsubstituted alkyl group having 10 to 20 carbon atoms, or a substituted or unsubstituted aryl (poly) heteroalkylene group having 10 to 20 carbon atoms), an imidazolium salt having a substituted or unsubstituted alkyl group having 10 to 20 carbon atoms, or a pyridinium salt having a substituted or unsubstituted alkyl group having 10 to 20 carbon atoms, more preferably an ammonium salt represented by the formula (1) (wherein R¹ is a substituted or unsubstituted aryl (poly) heteroalkylene group having 16 to 20 carbon atoms, and at least one of R²s is a substituted or unsubstituted aryl group having 6 to 12 carbon atoms), an imidazolium salt having a substituted or unsubstituted alkyl group having 10 to 16 carbon atoms, or a pyridinium salt having a substituted or unsubstituted alkyl group having 10 to 16 carbon atoms, still more preferably an ammonium salt represented by the formula (1) (wherein R¹ is a substituted or unsubstituted aryl (poly) heteroalkylene group having 18 to 20 carbon atoms, and at least one of R²s is a substituted or unsubstituted aryl group having 6 to 12 carbon atoms), an imidazolium salt having a substituted or unsubstituted alkyl group having 10 to 14 carbon atoms, or a pyridinium salt having a substituted or unsubstituted alkyl group having 10 to 14 carbon atoms, particularly preferably an ammonium salt represented by the formula (1) (wherein R¹ is a substituted or unsubstituted aryl (poly) heteroalkylene group having 18 to 20 carbon atoms, and at least one of R²s is a substituted or unsubstituted aryl group having 6 to 12 carbon atoms) or a pyridinium salt having a substituted or unsubstituted alkyl group having 10 to 14 carbon atoms, and most preferably benzetonium chloride or benzetonium bromide.

Note that the (B) metal-tungsten corrosion inhibitor described above may be used alone, or two or more kinds thereof may be used in combination. That is, in a preferred embodiment, the (B) metal-tungsten corrosion inhibitor preferably contains at least one selected from the group consisting of an ammonium salt represented by the formula (1) (here, R¹ is a substituted or unsubstituted alkyl group having 10 to 20 carbon atoms, or a substituted or unsubstituted aryl (poly) heteroalkylene group having 10 to 20 carbon atoms), an imidazolium salt having a substituted or unsubstituted alkyl group having 10 to 20 carbon atoms, and a pyridinium salt having a substituted or unsubstituted alkyl group having 10 to 20 carbon atoms, more preferably contains at least one selected from the group consisting of an ammonium salt represented by the formula (1) (wherein R¹ is a substituted or unsubstituted aryl (poly) heteroalkylene group having 16 to 20 carbon atoms, and at least one of R²s is a substituted or unsubstituted aryl group having 6 to 12 carbon atoms), an imidazolium salt having a substituted or unsubstituted alkyl group having 10 to 16 carbon atoms, and a pyridinium salt having a substituted or unsubstituted alkyl group having 10 to 16 carbon atoms, still more preferably contains at least one selected from the group consisting of an ammonium salt represented by the formula (1) (wherein R¹ is a substituted or unsubstituted aryl (poly) heteroalkylene group having 18 to 20 carbon atoms, and at least one of R²s is a substituted or unsubstituted aryl group having 6 to 12 carbon atoms), an imidazolium salt having a substituted or unsubstituted alkyl group having 10 to 14 carbon atoms, and a pyridinium salt having a substituted or unsubstituted alkyl group having 10 to 14 carbon atoms, particularly preferably contains at least one selected from the group consisting of an ammonium salt represented by the formula (1) (wherein R¹ is a substituted or unsubstituted aryl (poly) heteroalkylene group having 18 to 20 carbon atoms, and at least one of R²s is a substituted or unsubstituted aryl group having 6 to 12 carbon atoms) and a pyridinium salt having a substituted or unsubstituted alkyl group having 10 to 14 carbon atoms, and most preferably contains at least one selected from the group consisting of benzetonium chloride and benzetonium bromide.

The addition rate of the (B) metal-tungsten corrosion inhibitor is preferably 0.0001 to 5% by mass, more preferably 0.001 to 1% by mass, and still more preferably 0.003 to 0.5% by mass with respect to the total mass of the semiconductor substrate cleaning composition.

### [(C) Fluorine Compound]

(C) A fluorine compound is an optional component of the semiconductor substrate cleaning composition according to the present invention, and the semiconductor substrate cleaning composition may or may not contain the (C) fluorine compound. The (C) fluorine compound has a function of promoting etching of titanium and a titanium alloy changed to tetravalent.

In one embodiment, the semiconductor substrate cleaning composition does not contain the (C) fluorine compound. In one embodiment, when the semiconductor substrate cleaning composition contains the (C) fluorine compound, the addition rate thereof is less than 0.005% by mass, preferably 0.003% by mass or less, and more preferably 0.0001 to 0.003% by mass with respect to the total mass of the semiconductor substrate cleaning composition. As described above, the semiconductor substrate cleaning composition according to the present invention does not contain the (C) fluorine compound, or contains a small amount of the (C) fluorine compound, thereby making it possible to suppress etching of an oxide film containing an oxide having a relative dielectric constant of 60 or less, and to reduce damage to the oxide. From the viewpoint of increasing the Ti/W etching selectivity ratio, it is preferable that the semiconductor substrate cleaning composition does not contain the (C) fluorine compound.

The (C) fluorine compound is not particularly limited, and examples thereof include hydrofluoric acid (HF), tetrafluoroboric acid (HBF₄), hexafluorosilicic acid (H₂SiF₆), hexafluorozirconic acid (H₂ZrF₆), hexafluorotitanic acid (H₂TiF₆), hexafluorophosphoric acid (HPF₆), hexafluoroaluminic acid (H₂AlF₆), hexafluorogermanic acid (H₂GeF₆), and salts thereof.

At this time, examples of the salt include ammonium salts such as ammonium fluoride (NH₄F), acidic ammonium fluoride (NH₄F·HF), ammonium tetrafluoroborate (NH₄BF₄), ammonium hexafluorosilicate ((NH₄)₂SiF₆), and tetramethylammonium tetrafluoroborate (N(CH₃)₄BF₄).

In the above description, the (C) fluorine compound is preferably hydrofluoric acid (HF), tetrafluoroboric acid (HBF₄), hexafluorosilicic acid (H₂SiF₆), and salts thereof, more preferably hydrofluoric acid (HF), ammonium fluoride (NH₄F), acidic ammonium fluoride (NH₄F·HF), and hexafluorosilicic acid (H₂SiF₆), and still more preferably hydrofluoric acid (HF).

Note that the (C) fluorine compound described above may be used alone, or two or more kinds thereof may be used in combination.

### [(D) pH Adjusting Agent]

The semiconductor substrate cleaning composition may contain (D) a pH adjusting agent as necessary. In one embodiment, the semiconductor substrate cleaning composition preferably further contains the (D) pH adjusting agent.

Examples of the (D) pH adjusting agent can include the (A) oxidizing agent, an acid other than the (C) fluorine compound, and an alkali.

Examples of the acid include hydrogen chloride, hydrogen bromide, hydrogen iodide, sulfuric acid, nitric acid, methanesulfonic acid, trifluoromethanesulfonic acid, benzenesulfonic acid, p-toluenesulfonic acid, 10-camphorsulfonic acid, and salts thereof. At this time, examples of the salt include ammonium salts such as ammonium chloride, ammonium bromide, ammonium iodide, ammonium sulfate, and ammonium nitrate; and alkylammonium salts such as methylamine hydrochloride, dimethylamine hydrochloride, dimethylamine hydrobromide, and methylamine sulfate.

Examples of the alkali include lithium hydroxide, sodium hydroxide, potassium hydroxide, rubidium hydroxide, cesium hydroxide, beryllium hydroxide, magnesium hydroxide, calcium hydroxide, strontium hydroxide, barium hydroxide, ammonia, and triethylamine.

In the above description, the (D) pH adjusting agent is preferably hydrogen chloride, hydrogen bromide, hydrogen iodide, sulfuric acid, nitric acid, methanesulfonic acid, or ammonia, more preferably hydrogen chloride, sulfuric acid, or methanesulfonic acid, still more preferably hydrogen chloride or nitric acid from the viewpoint of increasing the Ti/W etching selectivity ratio, and still further more preferably nitric acid or sulfuric acid from the viewpoint of increasing the etching rate of titanium and a titanium alloy.

Note that the (D) pH adjusting agent may be used alone, or two or more kinds thereof may be used in combination. That is, in one preferred embodiment, the (D) pH adjusting agent preferably contains at least one selected from the group consisting of hydrogen chloride, hydrogen bromide, hydrogen iodide, sulfuric acid, nitric acid, methanesulfonic acid, and ammonia, more preferably contains at least one selected from the group consisting of hydrogen chloride, nitric acid, and sulfuric acid, still more preferably contains at least one selected from the group consisting of hydrogen chloride and nitric acid, or still further more preferably contains at least one selected from the group consisting of nitric acid and sulfuric acid.

The addition rate of the (D) pH adjusting agent varies depending on the pH of the semiconductor substrate cleaning composition before adjustment, but is preferably 0.0001 to 10% by mass, more preferably 0.001 to 7.5% by mass, still more preferably 0.005 to 3% by mass, and particularly preferably 0.1 to 2% by mass with respect to the total mass of the semiconductor substrate cleaning composition.

### [Water]

The semiconductor substrate cleaning composition preferably contains water. The water has a function of uniformly dispersing each component contained in the semiconductor substrate cleaning composition, a function of diluting each component, and the like.

The water is not particularly limited, and is preferably water from which metal ions, organic impurities, particles, and the like have been removed by distillation, an ion exchange treatment, a filter treatment, various adsorption treatments, or the like, more preferably pure water, and particularly preferably ultrapure water.

The addition rate of water is preferably 50% by mass or more, more preferably 80% by mass or more, still more preferably 90% by mass or more, and particularly preferably 90 to 99.99% by mass with respect to the total mass of the semiconductor substrate cleaning composition.

### [(E) Organic Solvent]

The semiconductor substrate cleaning composition may contain (E) an organic solvent as necessary.

The (E) organic solvent is not particularly limited, and examples thereof may include an alcohol such as a monoalcohol (methanol, ethanol, 1-propanol, 2-propanol, 1-butanol, tert-butanol, 1-pentanol, 1-hexanol, 1-heptanol, 1-octanol, 1-nonanol, 1-decanol, and the like), a diol (ethylene glycol, propylene glycol, neopentyl glycol, 1,2-hexanediol, 1,6-hexanediol, 2-ethylhexane-1, 3-diol, and the like), or a polyhydric alcohol (glycerin and the like); ethers such as dimethyl ether, diethyl ether, tetrahydrofuran, and 1,4-dioxane; glycol ethers such as diethylene glycol monomethyl ether, diethylene glycol monoethyl ether, diethylene glycol monobutyl ether, propylene glycol monomethyl ether, propylene glycol monoethyl ether, dipropylene glycol monomethyl ether, tripropylene glycol monomethyl ether, dipropylene glycol dimethyl ether, dipropylene glycol monoethyl ether, propylene glycol n-propyl ether, dipropylene glycol n-propyl ether, tripropylene glycol n-propyl ether, propylene glycol n-butyl ether, dipropylene glycol n-butyl ether, tripropylene glycol n-butyl ether, tripropylene glycol n-butyl ether, and propylene glycol phenyl ether; and amides such as dimethylformamide, diethylformamide, dimethylacetamide, and N-methylpyrrolidone.

Among them, the (E) organic solvent is preferably an alcohol, more preferably monoalcohol or diol, and still more preferably 1-hexanol, 1-heptanol, 1-octanol, 1-nonanol, 1-decanol, 1,2-hexanediol, 1,6-hexanediol, or 2-ethylhexane-1,3-diol, from the viewpoint of having a high boiling point and stability. Note that the (E) organic solvent may be used alone, or two or more kinds thereof may be used in combination.

The addition rate of the (E) organic solvent varies depending on the composition, surface tension, and the like of the semiconductor substrate cleaning composition before adjustment, and is preferably 50% by mass or less, more preferably 10% by mass or less, and still more preferably 0.01 to 5% by mass with respect to the total mass of the semiconductor substrate cleaning composition.

### [Iodine Scavenger]

When the (A) oxidizing agent contains an oxoacid of iodine, the semiconductor substrate cleaning composition preferably further contains an iodine scavenger.

The iodine scavenger is not particularly limited, and examples thereof include aliphatic ketones such as acetone, butanone, 2-methyl-2 butanone, 3,3-dimethyl-2 butanone, 4-hydroxy-2 butanone, 2-pentanone, 3-pentanone, 3-methyl-2-pentanone, 4-methyl-2-pentanone, 2-methyl-3 pentanone, 5-methyl-3-pentanone, 2,4-dimethyl-3-pentanone, 5-hydroxy-2-pentanone, 4-hydroxy-4-methyl-2-pentanone, 2-hexanone, 3-hexanone, 2-heptanone, 3-heptanone, 4-heptanone, 5-methyl-2-heptanone, 5-methyl-3-heptanone, 2,6-dimethyl-4-heptanone, 2-octanone, 3-octanone, 4-octanone, cyclohexanone, 2,6-dimethylcyclohexanone, 2-acetylcyclohexanone, menthone, cyclopentanone, and dicyclohexyl ketone; aliphatic diketones such as 2,5-hexanedione, 2,4-pentanedione, and acetylacetone; and aromatic ketones such as acetophenone, 1-phenylethanone, and benzophenone. Among them, the iodine scavenger is preferably an aliphatic ketone, more preferably 4-methyl-2-pentanone, 5-methyl-3-pentanone, 2,4-dimethyl-3-pentanone, or cyclohexanone, and still more preferably 4-methyl-2-pentanone. Note that these iodine scavengers may be used alone, or two or more kinds thereof may be used in combination.

### [Low Dielectric Constant Passivator]

The semiconductor substrate cleaning composition may further contain a low dielectric constant passivator. The low dielectric constant passivator has a function of preventing or suppressing etching of a low dielectric constant film, for example, an insulating film.

The low dielectric constant passivator is not particularly limited, and examples thereof include boric acid; borates such as ammonium pentaborate and sodium tetraborate; carboxylic acids such as 3-hydroxy-2-naphthoic acid, malonic acid, and iminodiacetic acid.

These low dielectric constant passivators may be used alone, or two or more kinds thereof may be used in combination.

The addition rate of the low dielectric constant passivator is preferably 0.01 to 2% by mass, more preferably 0.02 to 1% by mass, and still more preferably 0.03 to 0.5% by mass with respect to the total mass of the semiconductor substrate cleaning composition.

### [Additive]

The semiconductor substrate cleaning composition may further contain an additive. Examples of the additive include a surfactant, a chelating agent, an antifoaming agent, and a silicon-containing compound.

### [Physical Properties]

The pH of the semiconductor substrate cleaning composition is 7 or less, preferably 0.1 to 3, more preferably 0.5 to 3, still more preferably 0.5 to 2.5, and particularly preferably 0.75 to 1.5. When the pH of the semiconductor substrate cleaning composition is 7 or less, etching of an oxide film containing an oxide having a relative dielectric constant of 60 or less can be suppressed, thereby making it possible to reduce damage to the oxide. In the present specification, pH is measured by a method described in examples. In addition, the pH of the semiconductor substrate cleaning composition can be adjusted by, for example, adding the (D) pH adjusting agent.

### <Method for Producing Semiconductor Substrate>

According to an embodiment of the present invention, a method for producing a semiconductor substrate is provided. The method for producing a semiconductor substrate includes a step of bringing the semiconductor substrate including a titanium-containing film containing at least one of titanium and a titanium alloy, a metal tungsten film, and an oxide film containing an oxide having a relative dielectric constant of 60 or less into contact with the semiconductor substrate cleaning composition according to any one of claims 1 to 6 to remove at least a part of the titanium-containing film.

### [Semiconductor Substrate]

A semiconductor substrate includes a titanium-containing film containing at least one of titanium and a titanium alloy, a metal tungsten film, and an oxide film containing an oxide having a relative dielectric constant of 60 or less. The configuration of the semiconductor substrate is not particularly limited, and a known configuration can be appropriately adopted.

For example, the titanium-containing film can be included in the semiconductor substrate as a barrier metal film. In addition, the titanium-containing film can be included in the semiconductor substrate as a metal hard mask.

The metal tungsten film contains metal tungsten, and may optionally contain a component other than metal tungsten, for example, tungsten oxide.

An oxide film containing an oxide having a relative dielectric constant of 60 or less can be usually included in a semiconductor substrate as an insulating film.

The oxide having a relative dielectric constant of 60 or less is not particularly limited, and examples thereof include low dielectric constant insulators (low-κ insulators) such as methylated silsesquioxane (MSQ, relative dielectric constant: 2.7 to 3.2), silicon oxycarbide (SiOC, relative dielectric constant: 2.8 to 3.3), hydrosilsesquioxane (HSQ, relative dielectric constant: 3.1 to 3.6), fluorine-added silicon oxide (SiOF, relative dielectric constant: 3.2 to 3.8), silicon oxide (SiO₂, relative dielectric constant: 4.52 to 4.64), and boron phosphorus glass (BPGS, relative dielectric constant: 5); and high dielectric constant insulators (high-κ insulators) such as alumina (Al₂O₃, relative dielectric constant: 9.34 to 11.54), yttria (Ti₂O₃, relative dielectric constant: 15), zirconia (Zr₂O, relative dielectric constant: 12.5), hafnia (HfO₂, relative dielectric constant: 25), tantalum pentoxide (Ta₂O₅, relative dielectric constant: 26), and lanthanum (La₂O₃, relative dielectric constant: 30).

Among them, the oxide having a relative dielectric constant of 60 or less is preferably an oxide having a relative dielectric constant of 25 or less, more preferably an oxide having a relative dielectric constant of 20 or less, preferably an oxide having a relative dielectric constant of 10 or less, particularly preferably silicon oxide (SiO₂) or alumina (Al₂O₃), and most preferably silicon oxide (SiO₂).

The content form of the titanium-containing film, the metal tungsten film, and the oxide film in the semiconductor substrate can be appropriately set according to the application of the semiconductor substrate to be described later, as illustrated in Figs. 1, 2, and 3.

### [Semiconductor Substrate Cleaning Composition]

As the semiconductor substrate cleaning composition, those described above are used.

### [Contact]

The method for contacting the semiconductor substrate with the semiconductor substrate cleaning composition is not particularly limited, and a known technique can be appropriately adopted. Specifically, the semiconductor substrate may be immersed in the semiconductor substrate cleaning composition, the semiconductor substrate cleaning composition may be sprayed onto the semiconductor substrate, or the semiconductor substrate cleaning composition may be dropped thereonto (sheet spin treatment or the like). In this case, the immersion may be repeated two or more times, the spraying may be repeated two or more times, the dropping may be repeated two or more times, or the immersion, the spraying, and the dropping may be combined.

The contact temperature is not particularly limited, and is preferably 0 to 90°C, more preferably 15 to 70°C, and still more preferably 20 to 60°C.

The contact time is not particularly limited, and is preferably 10 seconds to 3 hours, more preferably 30 seconds to 1 hour, still more preferably 1 to 45 minutes, and particularly preferably 1 to 30 minutes.

The titanium-titanium alloy can be selectively etched by bringing the semiconductor substrate into contact with the semiconductor substrate cleaning composition.

### [Application of Semiconductor Substrate]

The obtained semiconductor substrate can be used for various applications. For example, the semiconductor substrate can be used for a memory element such as a DRAM or a NAND, a logic element such as a CPU, and the like. An electronic device using such a semiconductor substrate can be reduced in size and enhanced in function.

### Examples

Hereinafter, the present invention will be specifically described with reference to examples, but the present invention is not limited thereto.

### [Example 1]

Hydrogen peroxide (H₂O₂) serving as an (A) oxidizing agent, benzetonium chloride (BZT) serving as a (B) metal-tungsten corrosion inhibitor, and sulfuric acid serving as a pH adjusting agent were added to pure water, and an obtained mixture is stirred, thereby producing a semiconductor substrate cleaning composition. At this time, the addition rates of hydrogen peroxide, benzetonium chloride (BZT), and sulfuric acid were 1% by mass, 0.01% by mass, and 0.5% by mass, respectively, with respect to the total mass of the semiconductor substrate cleaning composition. Further, the pH of the semiconductor substrate cleaning composition was 1.3. Note that the pH of the semiconductor substrate cleaning composition at 20°C was measured using a tabletop pH meter (F-71) and a pH electrode (9615S-10D) manufactured by HORIBA, Ltd.

### [Examples 2 to 17 and Comparative Example 1]

A semiconductor substrate cleaning composition was produced by changing components and the like to be added, as shown in the following Table 1. Note that the pH was measured in the same manner as in the example 1.

**[Table 1]**

| | (A) Oxidizing Agent | | (B) Metal-tungsten Corrosion Inhibitor | | (C) Fluorine Compound | | pH adjusting agent | | Water | pH |
|---|---|---|---|---|---|---|---|---|---|---|
| | Type | Addition rate (% by mass) | Type* | Addition rate (% by mass) | Type | Addition rate (% by mass) | Type | Addition rate (% by mass) | Addition rate (% by mass) | |
| Example 1 | Hydrogen peroxide | 1 | BZT | 0.01 | - | - | Sulfuric acid | 0.5 | 98.5 | 1.3 |
| Example 2 | Hydrogen peroxide | 0.1 | BZT | 0.01 | - | - | Sulfuric acid | 0.5 | 99.4 | 1.2 |
| Example 3 | Iodic acid | 0.1 | BZT | 0.01 | - | - | Sulfuric acid | 0.5 | 99.4 | 1.2 |
| Example 4 | Periodic acid | 0.1 | BZT | 0.01 | - | - | Sulfuric acid | 0.5 | 99.4 | 1.2 |
| Example 5 | Hydrogen peroxide | 10 | BZT | 0.1 | - | - | Sulfuric acid | 0.5 | 89.4 | 1.0 |
| Example 6 | Iodic acid | 0.005 | BZT | 0.005 | - | - | Sulfuric acid | 0.5 | 99.5 | 1.2 |
| Example 7 | Hydrogen peroxide | 1 | BDMOctDAC | 0.01 | - | - | Sulfuric acid | 0.5 | 98.5 | 1.2 |
| Example 8 | Hydrogen peroxide | 1 | HexDMIC | 0.01 | - | - | Sulfuric acid | 0.5 | 98.5 | 1.2 |
| Example 9 | Hydrogen peroxide | 1 | HexDPC | 0.01 | - | - | Sulfuric acid | 0.5 | 98.5 | 1.2 |
| Example 10 | Hydrogen peroxide | 1 | DPC | 0.01 | - | - | Sulfuric acid | 0.5 | 98.5 | 1.2 |
| Example 11 | Hydrogen peroxide | 1 | BZT | 0.01 | - | - | Nitric acid | 0.5 | 98.5 | 1.2 |
| Example 12 | Hydrogen peroxide | 1 | BZT | 0.01 | - | - | Hydrochloric acid | 0.5 | 98.5 | 0.9 |
| Example 13 | Hydrogen peroxide | 1 | BZT | 0.01 | - | - | Sulfuric acid | 5 | 94.0 | 0.4 |
| Example 14 | Hydrogen peroxide | 1 | BZT | 0.01 | - | - | Sulfuric acid | 0.01 | 99.0 | 2.7 |
| Example 15 | Hydrogen peroxide | 1 | BZT | 0.01 | - | - | Sulfuric acid | 0.002 | 99.0 | 3.4 |
| Example 16 | Hydrogen peroxide | 1 | BZT | 0.01 | - | - | - | - | 99.0 | 5.6 |
| Example 17 | Iodic acid | 0.1 | BZT | 0.01 | - | - | - | - | 99.9 | 2.3 |
| Example 18 | Hydrogen peroxide | 1 | BZT | 0.01 | HF | 0.002 | Sulfuric acid | 0.5 | 98.5 | 1.2 |
| Example 19 | Hydrogen peroxide | 1 | BZT | 0.01 | HF | 0.002 | - | - | 99.0 | 3.4 |
| Comparative Example 1 | Hydrogen peroxide | 1 | BZT | 0.01 | HF | 0.1 | Sulfuric acid | 0.5 | 98.4 | 1.3 |
| Comparative Example 2 | Hydrogen peroxide | 1 | BZT | 0.01 | HF | 0.05 | - | - | 98.9 | 2.5 |
| Comparative Example 3 | Hydrogen peroxide | 1 | BZT | 0.01 | - | - | Ammonia | 0.1 | 98.9 | 10.1 |

| | | | | | | | | | | |
|---|---|---|---|---|---|---|---|---|---|---|
| *BZT: benzetonium chloride, BDMOctDAC: benzyldimethylstearylammonium chloride, HexDMIC: 1-hexadecyl-3-methylimidazolium chloride, HexDPC: 1-hexadecylpyridinium chloride, DPC: dodecylpyridinium chloride | | | | | | | | | | |

The structures of BZT, BDMOctDA, HexDMIC, HexDPC, and DPC, which are the (B) metal-tungsten corrosion inhibitors used in the examples 1 to 19 and the comparative examples 1 to 3, are shown below.

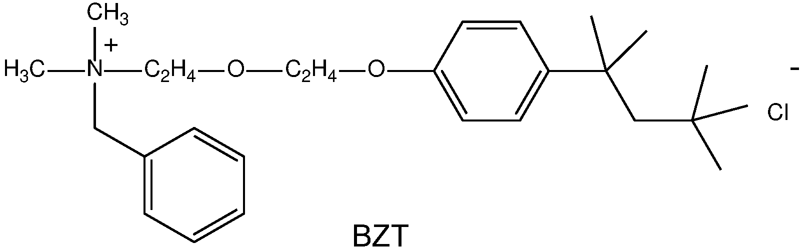

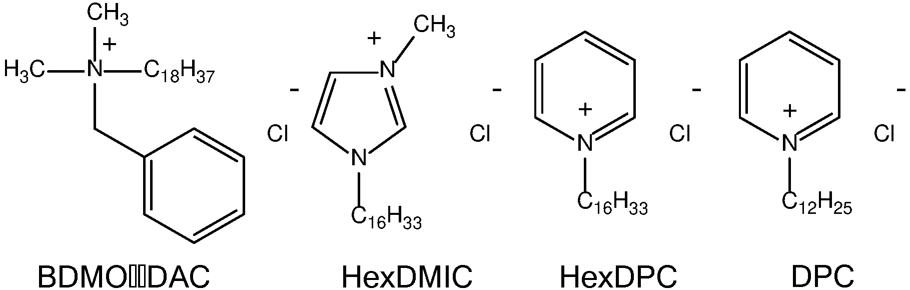

### [Evaluation]

The etching rates of the titanium nitride film, the metal tungsten film, the silicon oxide (TEOS) film, and the aluminum oxide (Al₂O₃) film of the semiconductor substrate cleaning composition produced in the examples 1 to 19 and the comparative examples 1 to 3, and the etching selectivity ratio of titanium nitride (TiN) to metal tungsten (W) (TiN/W etching selectivity ratio) were evaluated.

### [Evaluation]

The etching rate of the titanium nitride film, the metal tungsten film, the silicon oxide (TEOS) film, and the aluminum oxide (Al₂O₃) film of the semiconductor substrate cleaning composition produced in the examples 1 to 19 and the comparative examples 1 to 3, and the etching selectivity ratio of titanium nitride (TiN) to metal tungsten (W) (TiN/W etching selectivity ratio) were evaluated.

### (Etching Rate of Titanium Nitride (TiN) Film)

Titanium nitride (TiN) was deposited on a silicon wafer by physical vapor deposition until a thickness of titanium nitride reached 250 Å, and the silicon wafer was cut into a size of 2 cm × 2 cm (immersion treatment area: 4 cm²). Then, the silicon water was immersed in 1% hydrofluoric acid at 23°C for one minute. After immersion, the silicon water was rinsed with ultrapure water for 20 seconds, and the surface of the silicon water was dried by blowing nitrogen thereto, thereby preparing a titanium nitride film formation sample.

A film thickness of the titanium nitride film formation sample was measured using a fluorescent X-ray apparatus EA1200VX (manufactured by Hitachi high-tech).

The titanium nitride film formation sample was subjected to immersion treatment in 20 g of the semiconductor substrate cleaning composition produced in the examples 1 to 19 and the comparative examples 1 to 3 at 60°C while being stirred therein by a stirrer at 350 rpm. Note that the immersion treatment was performed for 10 minutes in the examples 1 to 10 and 13 to 19, and was performed for one minute in the examples 11 and 12 and the comparative examples 1 to 3.

The film thickness of the titanium nitride film formation sample after the immersion treatment using the semiconductor substrate cleaning composition was measured by the same method as described above.

A film thickness difference of the titanium nitride film formation sample before and after the immersion treatment using the semiconductor substrate cleaning composition was calculated and divided by a period of time during which the immersion treatment was performed using the semiconductor substrate cleaning composition, thereby calculating the etching rate (E.R.) of the titanium nitride film. The obtained results are shown in Table 2 below.

### (Etching Rate of Metal Tungsten Film)

A metal tungsten film (W) was deposited on a silicon wafer by chemical vapor deposition until a thickness of the metal tungsten film (W) reached 8000 Å, and the silicon wafer was cut into a size of 2 cm × 2 cm (immersion treatment area: 4 cm²), thereby preparing a metal tungsten film formation sample.

A film thickness of the metal tungsten film formation sample was measured using a fluorescent X-ray apparatus EA1200VX (manufactured by Hitachi high-tech).

The metal tungsten film formation sample was subjected to immersion treatment in 20 g of the semiconductor substrate cleaning composition produced in the examples 1 to 19 and the comparative examples 1 to 3 at 60°C for 120 minutes while being stirred therein by a stirrer at 350 rpm.

The film thickness of the metal tungsten film formation sample after the immersion treatment using the semiconductor substrate cleaning composition was measured by the same method as described above.

A film thickness difference of the metal tungsten film formation sample before and after the immersion treatment using the semiconductor substrate cleaning composition was calculated and divided by a period of time during which the immersion treatment was performed using the semiconductor substrate cleaning composition, thereby calculating the etching rate (E.R.) of the metal tungsten film. The obtained results are shown in Table 2 below.

### (Etching Rate of Silicon Oxide (TEOS) Film)

Silicon oxide was deposited on a silicon wafer by chemical vapor deposition until a thickness of silicon oxide reached 1000 Å, and the silicon wafer was cut into a size of 1 cm × 1 cm (immersion treatment area: 1 cm²), thereby preparing a silicon oxide film formation sample.

The film thickness of the silicon oxide film formation sample was measured using an optical film thickness meter n&k1280 (manufactured by n&k Technology, Inc.).

The silicon oxide film formation sample was subjected to immersion treatment in 20 g of the semiconductor substrate cleaning composition produced in the examples 1 to 19 and the comparative examples 1 to 3 at 60°C for 30 minutes while being stirred therein by a stirrer at 350 rpm.

The film thickness of the silicon oxide film formation sample after the immersion treatment was measured by the same method as described above.

A film thickness difference of the silicon oxide film formation sample before and after the immersion treatment was calculated and divided by a period of time during which the immersion treatment was performed using the semiconductor substrate cleaning composition, thereby calculating the etching rate (E.R.) of the silicon oxide film. The obtained results are shown in Table 2 below.

### (Etching Rate of Aluminum Oxide (Al₂O₃) Film)

Aluminum oxide was deposited on a silicon wafer by chemical vapor deposition until a thickness of aluminum oxide reached 1200 Å, and the silicon wafer was cut into a size of 1 cm × 1 cm (immersion treatment area: 1 cm²), thereby preparing an aluminum oxide film formation sample.

The film thickness of the aluminum oxide film formation sample was measured using an optical film thickness meter n&k1280 (manufactured by n&k Technology, Inc.).

The aluminum oxide film formation sample was subjected to immersion treatment in 20 g of the semiconductor substrate cleaning composition produced in the examples 1 to 19 and the comparative examples 1 to 3 at 60°C while being stirred therein by a stirrer at 350 rpm. Note that the immersion treatment was performed for 30 minutes in the examples 1 to 19, and was performed for two minutes in the comparative examples 1 to 3.

The film thickness of the aluminum oxide film formation sample after the immersion treatment was measured by the same method as described above.

A film thickness difference of the aluminum oxide film formation sample before and after the immersion treatment was calculated and divided by a period of time during which the immersion treatment was performed using the semiconductor substrate cleaning composition, thereby calculating the etching rate (E.R.) of the aluminum oxide film. The obtained results are shown in Table 2 below.

### [TiN/W Etching Selectivity Ratio]

The etching rate (E.R.) of the titanium nitride film of the semiconductor substrate cleaning composition produced in the examples 1 to 19 and the comparative examples 1 to 3 was divided by the etching rate (E.R.) of the metal tungsten film, thereby calculating TiN/W etching selectivity ratio. The obtained results are shown in Table 2 below.

**[Table 2]**

| | E.R. (Å/min) | | | | TiN/W etching selectivity ratio |
|---|---|---|---|---|---|
| | TiN | W | TEOS | Al₂O₃ | |
| Example 1 | 22.7 | 2.4 | < 0.03 | 4 | 9.6 |
| Example 2 | 7.5 | 0.3 | < 0.03 | 5 | 23.1 |
| Example 3 | 21.8 | 0.1 | < 0.03 | 4 | 436.0 |
| Example 4 | 2.9 | 0.1 | < 0.03 | 4 | 31.6 |
| Example 5 | 8.5 | 3.2 | 0.1 | 2 | 2.7 |
| Example 6 | 4.2 | < 0.009 | 0.1 | 5 | > 467 |
| Example 7 | 9 | 4.7 | 0.1 | 4 | 1.9 |
| Example 8 | 15.7 | 6.7 | < 0.03 | 5 | 2.3 |
| Example 9 | 13.9 | 4.6 | < 0.03 | 5 | 3.0 |
| Example 10 | 23.6 | 7.3 | 0.1 | 5 | 3.2 |
| Example 11 | 46 | 2.9 | < 0.03 | 12 | 16.1 |
| Example 12 | 48 | 5.6 | < 0.03 | 8 | 8.6 |
| Example 13 | 10.3 | 2.4 | < 0.03 | 10 | 4.2 |
| Example 14 | 12.8 | 1.8 | < 0.03 | 3 | 7.0 |
| Example 15 | 1.5 | 1.9 | 0.1 | 3 | 0.8 |
| Example 16 | 1.1 | 2.2 | < 0.03 | < 1 | 0.5 |
| Example 17 | 1.3 | < 0.009 | < 0.03 | 1 | > 144 |
| Example 18 | 10.6 | 2.4 | < 0.03 | 27 | 4.5 |
| Example 19 | 8 | 2.0 | < 0.03 | 32 | 4.1 |
| Comparative Example 1 | 50 | 0.9 | 4.3 | 623 | 58.3 |
| Comparative Example 2 | 67 | 1.0 | 2.7 | 624 | 69.9 |
| Comparative Example 3 | 66 | 37.3 | 0.4 | 557 | 1.8 |

From the results in Table 2, it can be seen that the semiconductor substrate cleaning composition produced in the examples 1 to 19 has a high Ti/W etching selectivity ratio and little damage to TEOS and Al₂O₃ having a relative dielectric constant of 60 or less. As a result, it is considered that the obtained semiconductor substrate exhibits high physical properties.

### Reference Signs List

- 10: Semiconductor Substrate (Before Etching)
- 11, 21: Silicon Substrate Having Recessed Portion
- 12, 22: Insulating Film
- 13: Barrier Metal Film (Before Etching)
- 14, 24: Metal Tungsten Film
- 20: Semiconductor Substrate (After Etching)
- 23: Barrier Metal Film (After Etching)
- 30: Semiconductor Substrate (Before Etching)
- 31-1: Silicon Substrate
- 31-2: Polysilicon
- 32, 42: Insulating Film
- 33, 43: High Dielectric Constant Insulating Film (High-K Film)
- 34: Barrier Metal Film (Before Etching)
- 35, 45: Metal Tungsten Film
- 40: Semiconductor Substrate (After Etching)
- 44: Barrier Metal Film (After Etching)
- 50: Semiconductor Substrate (Before Etching)
- 51, 61: Silicon Substrate Having Recessed Portion
- 52, 62: Barrier Metal Film
- 53, 63: Metal Tungsten Film
- 54, 64: Cap Film
- 55, 65: Low Dielectric Constant Insulating Film (Low-K Film)
- 56: Metal Hard Mask (Before Etching)
- 60: Semiconductor Substrate (After Etching)
- 66: Metal Hard Mask (After Etching)

## Claims

1. A semiconductor substrate cleaning composition comprising:
(A) an oxidizing agent; and
(B) a metal-tungsten corrosion inhibitor,
wherein the semiconductor substrate cleaning composition does not comprise (C) a fluorine compound or further comprises the fluorine compound in an amount of less than 0.005% by mass with respect to a total mass of the semiconductor substrate cleaning composition, and
the semiconductor substrate cleaning composition has a pH of 7 or less.

2. The semiconductor substrate cleaning composition according to claim 1, wherein the semiconductor substrate cleaning composition does not comprise the (C) fluorine compound.

3. The semiconductor substrate cleaning composition according to claim 1, wherein the pH is 0.5 to 3.

4. The semiconductor substrate cleaning composition according to claim 1, wherein the (A) oxidizing agent includes at least one selected from a group consisting of a peracid, a halogen oxoacid, and a salt thereof.

5. The semiconductor substrate cleaning composition according to claim 1, wherein the (B) metal-tungsten corrosion inhibitor includes at least one selected from a group consisting of an ammonium salt represented by a formula (1) and a heteroaryl salt having a substituted or unsubstituted alkyl group having 10 to 30 carbon atoms, 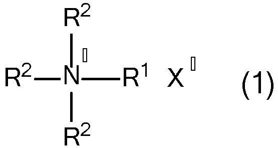 (in the formula (1),
R¹ is the substituted or unsubstituted alkyl group having 10 to 30 carbon atoms, a substituted or unsubstituted alkyl (poly) heteroalkylene group having 10 to 30 carbon atoms, or a substituted or unsubstituted aryl (poly) heteroalkylene group having 10 to 30 carbon atoms,
R² is each independently the substituted or unsubstituted alkyl group having 1 to 30 carbon atoms, or a substituted or unsubstituted aryl group having 6 to 30 carbon atoms, and
X⁻ is a halide ion, a hydroxide ion, an organic sulfonate ion, a tetrafluoroborate anion, or a hexafluorophosphate anion).

6. The semiconductor substrate cleaning composition according to claim 5, wherein
the R¹ is the substituted or unsubstituted aryl (poly) heteroalkylene group having 10 to 30 carbon atoms, and
at least one of the R²s is the substituted or unsubstituted aryl group having 6 to 30 carbon atoms.

7. A method for producing a semiconductor substrate, the method comprising a step of causing the semiconductor substrate including a titanium-containing film containing at least one of titanium and a titanium alloy, a metal tungsten film, and an oxide film containing an oxide having a relative dielectric constant of 60 or less to contact the semiconductor substrate cleaning composition according to any one of claims 1 to 6 so as to remove at least a part of the titanium-containing film.
